# EUROPÄISCHE PATENTSCHRIFT

(11) **EP 3 255 966 B1**
(45) Veröffentlichungstag und Bekanntmachung des Hinweises auf die Patenterteilung: **07.08.2019**
(21) Anmeldenummer: 17173993.1
(22) Anmeldetag: 01.06.2017
(51) Int. Cl.: H05K 5/02

(54) **GEHÄUSE EINES ELEKTRISCHEN UND/ODER ELEKTRONISCHEN GERÄTES**
HOUSING FOR AN ELECTRICAL AND/OR ELECTRONIC DEVICE
BOÎTIER D'UN APPAREIL ÉLECTRIQUE OU ÉLECTRONIQUE

(30) Priorität: 09.06.2016 DE 202016103069 U
(43) Veröffentlichungstag der Anmeldung: 13.12.2017
(73) Patentinhaber: WAGO Verwaltungsgesellschaft mbH, 32423 Minden (DE)
(72) Erfinder: BINNER, Lars, 49326 Melle (DE)
(74) Vertreter: Gramm, Lins & Partner Patent- und Rechtsanwälte PartGmbB

(56) Entgegenhaltungen:
- DE-A1- 2 745 531
- DE-A1- 2 834 590
- DE-A1- 10 305 931
- DE-C1- 19 809 293
- DE-U1-202004 004 629
- US-A1- 2010 320 342

## Beschreibung

Die Erfindung betrifft ein Gehäuse eines elektrischen und/oder elektronischen Gerätes, wobei das Gehäuse wenigstens ein Gehäuseoberteil und ein mit dem Gehäuseoberteil verbindbares Gehäuseunterteil aufweist und das Gehäuse im zusammengebauten Zustand des Gehäuseoberteils mit dem Gehäuseunterteil einen Gehäuseinnenraum umgibt, in dem elektrische und/oder elektronische Komponenten des Gerätes angeordnet werden können, wobei das Gehäuseunterteil Befestigungsmittel aufweist, die mit korrespondierenden Befestigungsmitteln des Gehäuseoberteils zur Verbindung des Gehäuseunterteils mit dem Gehäuseoberteil zusammenfügbar sind, wobei das Gehäuseunterteil eine erste Gehäuseseite und eine zweite Gehäuseseite aufweist, die von der ersten Gehäuseseite fort weist.

Derartige Gehäuse, die auch mit dem Sammelbegriff Elektronikgehäuse bezeichnet werden, dienen zur Aufnahme elektrischer und/oder elektronischer Komponenten jeder Art, z.B. Leiterplatten mit darauf angeordneten elektrischen und/oder elektronischen Bauteilen, oder für einzelne solcher Bauteile. Solche zumindest zweiteiligen Elektronikgehäuse sind allgemein bekannt.

Aus der DE 28 34 590 A1 ist ein elektronisches Warn-Schutz-Schalt- und Stromversorgungsgerät bekannt, das universell verwendbar ist.

Aus der DE 20 2004 004 629 U1 ist eine Vorrichtung zur Montage eines kastenförmigen, standardisierten Gehäuses mit vorgegebenen, standardisierten Befestigungspunkten bekannt.

Der Erfindung liegt die Aufgabe zugrunde, ein Gehäuse anzugeben, das hinsichtlich seiner Einsatzmöglichkeiten sehr universell ist.

Diese Aufgabe wird bei einem Gehäuse der eingangs genannten Art dadurch gelöst, dass das Gehäuseunterteil in wenigstens zwei unterschiedlichen Lagen mittels seiner Befestigungsmittel mit den korrespondierenden Befestigungsmitteln des Gehäuseoberteils zur Verbindung des Gehäuseunterteils mit dem Gehäuseoberteil zusammenfügbar ist, derart, dass in einer ersten Lage die zweite Gehäuseseite des Gehäuseunterteils zum Gehäuseoberteil hin ausgerichtet ist und in einer zweiten Lage die erste Gehäuseseite des Gehäuseunterteils zum Gehäuseoberteil hin ausgerichtet ist, wobei das Gehäuse zur Montage des Gehäuseunterteils auf einem ersten Befestigungsuntergrund eingerichtet ist, wenn sich das Gehäuseunterteil in seiner ersten Lage befindet, und das Gehäuse zur Montage des Gehäuseunterteils auf einem zweiten Befestigungsuntergrund eingerichtet ist, wenn sich das Gehäuseunterteil in seiner zweiten Lage befindet, wobei der zweite Befestigungsuntergrund sich von dem ersten Befestigungsuntergrund unterscheidet. Dementsprechend ist das Gehäuseunterteil um 180 Grad wendbar wahlweise in jeder der zwei genannten Lagen an dem Gehäuseoberteil befestigbar. Bei einer solchen Befestigung des Gehäuseunterteils am Gehäuseoberteil weist somit in der ersten Lage die zweite Gehäuseseite des Gehäuseunterteils zum Gehäuseoberteil hin, dementsprechend weist die erste Gehäuseseite in dieser ersten Lage vom Gehäuseoberteil fort und ist somit zur Außenumgebung des Gehäuses gewandt. In der zweiten Lage weist die erste Gehäuseseite des Gehäuseunterteils zum Gehäuseoberteil hin, dementsprechend weist die zweite Gehäuseseite dann vom Gehäuseoberteil fort und ist dementsprechend zur Außenumgebung des Gehäuses gewandt.

Bei dem erfindungsgemäßen Gehäuse kann somit wahlweise entweder die erste Gehäuseseite oder die zweite Gehäuseseite des Gehäuseunterteils eine zum Gehäuseinnenraum gewandte Innenseite des Gehäuses bilden. Dementsprechend kann wahlweise auch die erste oder zweite Gehäuseseite des Gehäuseunterteils eine zur Außenumgebung gewandte Außenseite des Gehäuses bilden. Das Gehäuseunterteil muss an seiner ersten bzw. an seiner zweiten Gehäuseseite nicht unbedingt vollständig geschlossen sein, z.B. durch eine Gehäusewand, sondern kann auch Öffnungen und Durchbrüche aufweisen.

Ein Vorteil der Erfindung besteht darin, dass sich das erfindungsgemäße Gehäuse durch sein universelles Gehäuseunterteil zur einfachen Montage des Gehäuses an unterschiedlichen Befestigungsuntergründen eignet, wobei der Anwender lediglich die geeignete Lage des Gehäuseunterteils (erste oder zweite Lage) auswählen muss und dann ein für die Montage an einem bestimmten Befestigungsuntergrund geeignetes Gehäuse hat. Das erfindungsgemäße Gehäuse eignet sich auf diese Weise insbesondere auch in solchen Fällen, in denen der erste Befestigungsuntergrund inkompatibel zum zweiten Befestigungsuntergrund ist, insbesondere wenn der zweite Befestigungsuntergrund hinsichtlich der notwendigen Befestigungseinrichtungen des Gehäuseunterteils inkompatibel mit dem ersten Befestigungsuntergrund ist. So kann das Gehäuseunterteil z.B. dafür eingerichtet sein, in der ersten Lage wahlweise an einer Wand, einer Decke oder über Unterputzdosen als Aufputzgerät montiert zu werden, oder alternativ in der zweiten Lage an einer Tragschiene der elektrischen Installationstechnik montiert zu werden, z.B. in einem Schaltschrank.

Auf diese Weise kann das Gehäuseunterteil zugleich die Funktion eines Montageadapters beinhalten, mit dem das erfindungsgemäße Gehäuse an unterschiedliche Befestigungsuntergründe adaptiert werden kann. Dementsprechend ist ein weiterer Vorteil der Erfindung darin zu sehen, dass kein gesonderter Montageadapter für die Anpassung der Befestigung des Gehäuses an unterschiedlichen Befestigungsuntergründen erforderlich ist. Hierdurch werden Kosten und Bauraum gespart.

Gemäß einer vorteilhaften Weiterbildung der Erfindung ist vorgesehen, dass das Gehäuseunterteil erste Befestigungseinrichtungen, die in der ersten Lage wirksam sind und zur Montage des Gehäuseunterteils auf dem ersten Befestigungsuntergrund eingerichtet sind, und zweite Befestigungseinrichtungen aufweist, die in der zweiten Lage wirksam sind und zur Montage des Gehäuseunterteils auf dem zweiten Befestigungsuntergrund eingerichtet sind. Auf diese Weise kann durch unterschiedlich ausgebildete erste und zweite Befestigungseinrichtungen die spezielle Montagesituation bei der Montage des Gehäuseunterteils an dem ersten oder dem zweiten Befestigungsuntergrund berücksichtigt werden. Insbesondere kann zumindest eine der Befestigungseinrichtungen, d.h. entweder die ersten Befestigungseinrichtungen oder die zweiten Befestigungseinrichtungen, derart ausgebildet sein, dass sie nur in der einen, ihnen jeweils zugeordneten Lage (erste oder zweite Lage) wirksam sind und in der jeweils anderen Lage unwirksam sind, d.h. dass sie sich in diesem unwirksamen Zustand nicht zur Montage des Gehäuseunterteils auf dem ihnen jeweils zugeordneten Befestigungsuntergrund geeignet sind.

Das Gehäuseunterteil kann insbesondere derart ausgebildet sein, dass es auf der ersten Gehäuseseite erste Befestigungseinrichtungen der zuvor genannten Art und/oder auf der zweiten Gehäuseseite zweite Befestigungseinrichtungen der zuvor genannten Art aufweist.

Gemäß einer vorteilhaften Weiterbildung der Erfindung ist vorgesehen, dass die erste Befestigungseinrichtung als eines oder mehrere Befestigungslöcher ausgebildet ist, durch die Schrauben oder ähnliches für eine Befestigung des Gehäuseunterteils am ersten Befestigungsuntergrund geführt werden können. Dies erlaubt eine einfache und zuverlässige Befestigung des elektrischen Geräts an ebenen Befestigungsuntergründen, z.B. an einer Wand, einer Decke oder über Unterputzdosen als Aufputzgerät. Die Befestigungslöcher können als an der ersten Gehäuseseite zugängliche Bohrungen und/oder Schraubaufnahmen ausgebildet sein.

Gemäß einer vorteilhaften Weiterbildung der Erfindung ist vorgesehen, dass die zweite Befestigungseinrichtung als Rasteinrichtung zur rastenden Befestigung des Gehäuseunterteils an einer Tragschiene der elektrischen Installationstechnik ausgebildet ist. Auf diese Weise kann das erfindungsgemäße Gehäuse auch auf einfache und schnelle Weise an einer derartigen Tragschiene befestigt werden. Die Befestigung kann insbesondere mit einer Verschwenkbewegung erfolgen. Durch die rastende Befestigung ist eine einfache und schnelle Installation an der Tragschiene möglich, ebenso wie ein späteres, einfaches Entfernen des Gehäuses von der Tragschiene.

Gemäß einer vorteilhaften Weiterbildung der Erfindung ist vorgesehen, dass die Rasteinrichtung wenigstens einen von der zweiten Gehäuseseite abragenden Rasthaken aufweist, der zum Einrasten an einer ersten Rastkante der Tragschiene eingerichtet ist. Dies erlaubt ein einfaches und bequemes Befestigen des Gehäuses an der Tragschiene, wobei der übliche Bewegungsablauf bei der Befestigung von Geräten an Tragschienen beibehalten werden kann. An der zweiten Gehäuseseite kann z.B. ein einziger Rasthaken oder zwei voneinander beabstandete Rasthaken angeordnet sein.

Gemäß einer vorteilhaften Weiterbildung der Erfindung ist vorgesehen, dass die Rasteinrichtung wenigstens eine von der zweiten Gehäuseseite abragende Rastfedereinrichtung aufweist, die zum federnden Einrasten auf einer zweiten Rastkante der Tragschiene, die von der ersten Rastkante abgewandt ist, eingerichtet ist. Auf diese Weise kann das Gehäuse mittels der genannten Verschwenkbewegung bequem an der Tragschiene befestigt werden, da die Rastfedereinrichtung nachgibt und das Gerät bzw. das Gehäuse dann mit leichtem Druck an der Tragschiene fixiert werden kann. Die Rastfedereinrichtung kann z.B. eine oder zwei voneinander beabstandete Rastfedern und/oder einen gefederten, linear beweglichen Rastschlitten aufweisen.

Gemäß einer vorteilhaften Weiterbildung der Erfindung ist vorgesehen, dass das Gehäuseunterteil auf der ersten Gehäuseseite Befestigungsmittel aufweist, die mit korrespondierenden Befestigungsmitteln des Gehäuseoberteils zur Verbindung des Gehäuseunterteils mit dem Gehäuseoberteil zusammenfügbar sind, wenn die erste Gehäuseseite des Gehäuseunterteils zum Gehäuseoberteil ausgerichtet ist. Die Befestigungsmittel des Gehäuseunterteils, die mit korrespondierenden Befestigungsmitteln des Gehäuseoberteils zusammenfügbar sind, können z.B. als Schraublöcher ausgebildet sein. Dann können die damit korrespondierenden Befestigungsmittel z.B. als zum Einschrauben einer Schraube geeignete Gehäusebolzen oder Bohrungen ausgebildet sein. Die Befestigungsmittel und die damit korrespondierenden Befestigungsmittel können auch als miteinander zusammenfügbare Rastverbindung ausgebildet sein, z.B. in Form von Rasthaken und damit korrespondierenden Rastkanten.

Gemäß einer vorteilhaften Weiterbildung der Erfindung ist vorgesehen, dass das Gehäuseunterteil an der zweiten Gehäuseseite Befestigungsmittel aufweist, die mit den korrespondierenden Befestigungsmitteln des Gehäuseoberteils zur Verbindung des Gehäuseunterteils mit dem Gehäuseoberteil zusammenfügbar sind, wenn die zweite Gehäuseseite des Gehäuseunterteils zum Gehäuseoberteil ausgerichtet ist. Auf diese Weise können die gleichen Vorteile, wie zuvor bezüglich der ersten Gehäuseseite genannt, auch an der zweiten Gehäuseseite realisiert werden. Die an der zweiten Gehäuseseite wirksamen Befestigungsmittel des Gehäuseunterteils können insbesondere identisch mit den an der ersten Gehäuseseite wirksamen Befestigungsmitteln ausgebildet sein.

Gemäß einer vorteilhaften Weiterbildung der Erfindung ist vorgesehen, dass das Gehäuseoberteil einen Gehäusedeckel aufweist, durch den das Gehäuse an der vom Gehäuseunterteil fortweisenden Seite abgeschlossen ist. Auf diese Weise bildet das Gehäuseoberteil zugleich einen oberen Abschluss des Gehäuses. Dementsprechend kann das gesamte Gehäuse aus dem Gehäuseoberteil und dem Gehäuseunterteil gebildet werden.

Gemäß einer vorteilhaften Weiterbildung der Erfindung ist vorgesehen, dass das Gehäuse aus wenigstens den folgenden Teilen gebildet ist:
a) ein Gehäuseoberteil,
b) ein Gehäuseunterteil, das mit seinen Befestigungsmitteln an seiner ersten Gehäuseseite mit den korrespondierenden Befestigungsmitteln des Gehäuseoberteils zusammengefügt ist und damit am Gehäuseoberteil befestigt ist,
c) ein weiteres Gehäuseoberteil, das an zweiten Gehäuseseite des Gehäuseunterteils an diesem befestigt ist, indem die an der zweiten Gehäuseseite wirksamen Befestigungsmittel des Gehäuseunterteils mit den korrespondierenden Befestigungsmitteln des weiteren Gehäuseoberteils zusammengefügt sind.

Auf diese Weise kann mit den erfindungsgemäßen Teilen des Gehäuses eine weitere Variante des Gehäuses zusammengesetzt werden, das ein abgeschlossenes Gehäuse bilden kann. Durch eine Oberfläche des Gehäuseoberteils oder des weiteren Gehäuseoberteils kann z.B. eine Befestigungsfläche zur Befestigung des Gehäuses gebildet sein, z.B. in Form einer Klebefläche für eine Wand- und/oder Deckenmontage. Zudem kann diese Ausführungsform des erfindungsgemäßen Gehäuses zur Auflage auf Zwischendecken eingesetzt werden. Diese Variante des Gehäuses bietet einen erhöhten IP-Schutz, somit eine höhere Resistenz gegen Umgebungsbedingungen.

Gemäß einer vorteilhaften Weiterbildung der Erfindung ist vorgesehen, dass das Gehäuseoberteil zur Befestigung eines weiteren Gehäuseteils an der vom Gehäuseunterteil fortweisenden Seite des Gehäuseoberteils eingerichtet ist. Auf diese Weise kann das Gehäuse noch flexibler gestaltet werden, insbesondere in Form eines modular zusammensetzbaren Gehäuses, bei dem wahlweise gegebenenfalls auch mehrere weitere Gehäuseteile angebaut werden können, z.B. zur Vergrößerung des verfügbaren Gehäuseinnenraums.

Ist an dem Gehäuseoberteil noch ein weiteres Gehäuseteil an seiner vom Gehäuseunterteil fortweisenden Seite montiert, so bildet das Gehäuseoberteil somit nicht das oberste, das Gehäuse abschließende Gehäuseteil, sondern das weitere Gehäuseteil oder daran gegebenenfalls noch befestigte weitere Gehäuseteile. In einem solchen Fall muss das Gehäuseoberteil nicht unbedingt eine zum weiteren Gehäuseteil weisende, geschlossene Gehäuseseite haben. Vielmehr kann das Gehäuseoberteil in diesem Fall auch ganz oder teilweise an der vom Gehäuseunterteil fortweisenden Seite offen ausgebildet sein.

Die Erfindung wird nachfolgend anhand von Ausführungsbeispielen unter Verwendung von Zeichnungen näher erläutert.

Es zeigen
- Figuren 1 bis 6: - ein erfindungsgemäßes Gehäuse in einer ersten Ausführungsform in unterschiedlichen perspektivischen Ansichten und
- Figuren 7 bis 13: - eine zweite Ausführungsform eines erfindungsgemäßen Gehäuses in unterschiedlichen perspektivischen Ansichten und
- Figuren 14 bis 15: - eine dritte Ausführungsform eines erfindungsgemäßen Gehäuses in unterschiedlichen perspektivischen Ansichten.

In den Figuren werden gleiche Bezugszeichen für einander entsprechende Elemente verwendet.

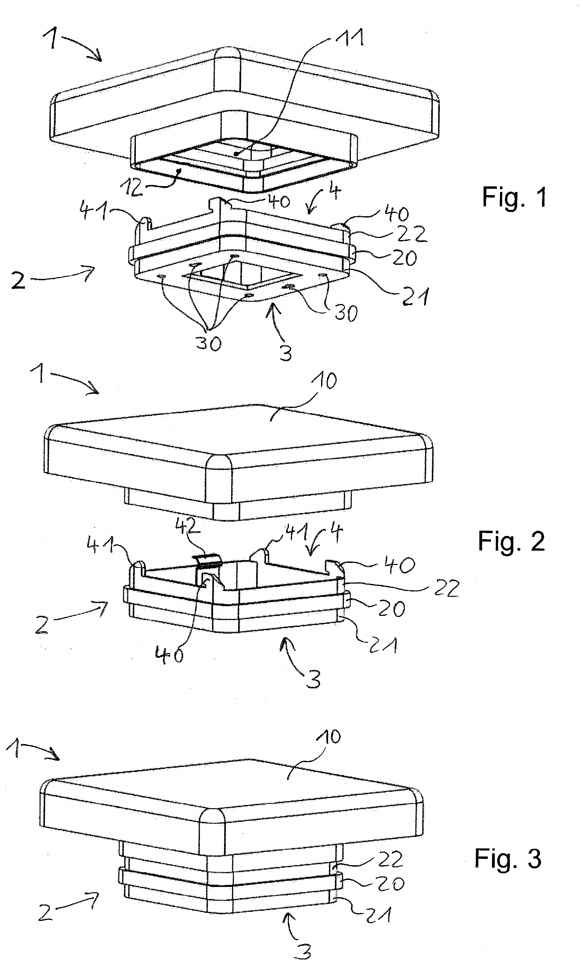

Die Figur 1 zeigt ein erstes Gehäuseteil 1 und ein zweites Gehäuseteil 2, zunächst als einzelne Teile, d.h. bevor diese zu einem Gehäuse zusammengesetzt sind. Das aus diesen Gehäuseteilen 1, 2 zu bildende Gehäuse weist einen Gehäuseinnenraum 11 auf, der im Wesentlichen durch das Gehäuseoberteil 1 bestimmt ist.

Das Gehäuseunterteil 2 weist eine erste Gehäuseseite 3 und eine davon abgewandte zweite Gehäuseseite 4 auf. Die Figur 1 zeigt das Gehäuseoberteil 1 und das Gehäuseunterteil 2 in einer Ansicht, in der ein Blick auf die erste Gehäuseseite 3 möglich ist, bei der Figur 2 ist ein Blick auf die zweite Gehäuseseite 4 möglich.

An dem Gehäuseunterteil 2 sind als erste Befestigungseinrichtungen 30 jeweilige Befestigungslöcher vorhanden. Ferner weist das Gehäuseunterteil 2 als zweite Befestigungseinrichtung eine Rasteinrichtung 40, 41, 42 auf, die zwei Rasthaken 40, gegenüberliegend zwei Justierfortsätze 41 sowie eine Rastfedereinrichtung 42 aufweist. Die Rastfedereinrichtung 42 ist in diesem Fall in Form einer einzelnen Rastfeder gebildet, z.B. durch einen elastischen Metallstreifen.

In den Figuren 1 bis 3 ist das Gehäuseunterteil 2 in seiner ersten Lage dargestellt, in der die zweite Gehäuseseite 4 zum Gehäuseoberteil 1 hin ausgerichtet ist. Dementsprechend weist die erste Gehäuseseite 3 vom Gehäuseoberteil 1 fort. Dementsprechend sind in dieser Lage die ersten Befestigungseinrichtungen 30 wirksam für eine Montage des Gehäuses mittels des Gehäuseunterteils 2 an einem ersten Montagegrund, z.B. an einer Wand oder Decke oder an einer Unterputzdose.

Um das Gehäuseoberteil 1 mit dem Gehäuseunterteil 2 zu verbinden, sind am Gehäuseunterteil 2 jeweils gleich ausgebildete, zur ersten und zur zweiten Gehäuseseite 3, 4 weisende Befestigungsmittel 21, 22 vorhanden, die durch einen umlaufenden Mittelsteg 20 voneinander getrennt sind. Diese Befestigungsmittel 21, 22 können mit dazu korrespondierenden Befestigungsmitteln 12 des Gehäuseoberteils 1 zusammengesetzt werden, wobei dann das Gehäuseunterteil 2 am Gehäuseoberteil 1 gehalten ist. Im dargestellten Ausführungsbeispiel können die korrespondierenden Befestigungsmittel 12, z.B. als ringförmig umlaufende Wand ausgebildet sein, die hinsichtlich der Abmessungen den äußeren Umfangsabmessungen des Gehäuseunterteils 2 im Bereich der Befestigungsmittel 21, 22 entspricht, sodass, wenn das Gehäuseunterteil 2 mit dem jeweiligen Befestigungsmittel 21, 22 in das korrespondierende Befestigungsmittel 12 eingesetzt wird, damit z.B. eine Klemmbefestigung hergestellt ist.

Die Figur 3 zeigt in einer zur Figur 2 vergleichbaren Perspektive das erfindungsgemäße Gehäuse mit dem an dem Gehäuseoberteil 1 befestigtem Gehäuseunterteil 2. Das Gehäuseoberteil 1 weist einen geschlossenen Gehäusedeckel 10 auf.

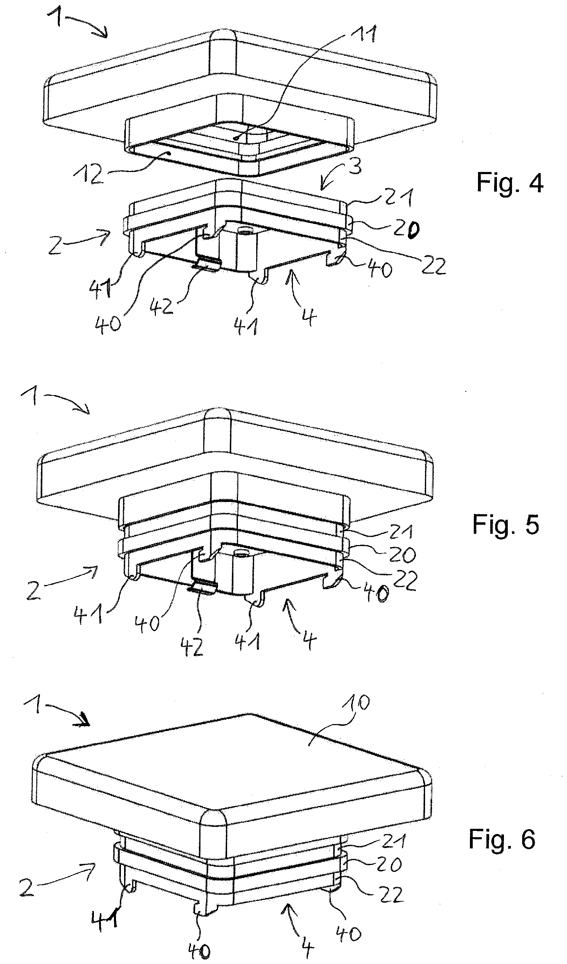

Die Figuren 4 bis 6 zeigen die gleichen Gehäuseteile 1, 2, mit dem Unterschied zu den Figuren 1 bis 3, dass sich nun das Gehäuseunterteil 2 in seiner zweiten Lage befindet, in der die erste Gehäuseseite 3 zum Gehäuseoberteil 1 hin ausgerichtet ist und die zweite Gehäuseseite 4 davon fort weist. Dementsprechend ist nun die zweite Befestigungseinrichtung 40, 41, 42 in Form der Rasteinrichtung wirksam. Mittels der Rasteinrichtung kann das Gehäuse mittels des Gehäuseunterteils 2 nun an einer Tragschiene aufgerastet werden. Die Rasthaken 40 hintergreifen dabei eine erste Rastkante der Tragschiene, die Rastfeder 42 die zweite, gegenüberliegende Rastkante der Tragschiene. Über die Justierfortsätze 41 wird das Gehäuseunterteil 2 an der zweiten Rastkante der Tragschiene zusätzlich gehalten und in der gewünschten Lage justiert.

Die Verbindung zwischen dem Gehäuseunterteil 2 und dem Gehäuseoberteil 1 wird in dieser zweiten Lage nun über das Befestigungsmittel 21 an der ersten Gehäuseseite 3 zusammen mit dem korrespondierenden Befestigungsmittel 12 des Gehäuseoberteils 1 hergestellt, wiederum als Klemmbefestigung.

Wie die bisher beschriebenen Figuren 1 bis 6 zeigen, eignet sich die vorliegende Erfindung für Gehäusebauformen mit im Wesentlichen quadratischer oder rechteckiger Querschnittsform. Die Erfindung eignet sich auch für andere Gehäusebauformen, z.B. Gehäuse mit runder Querschnittsform, wie die nachfolgenden Ausführungsbeispiele zeigen.

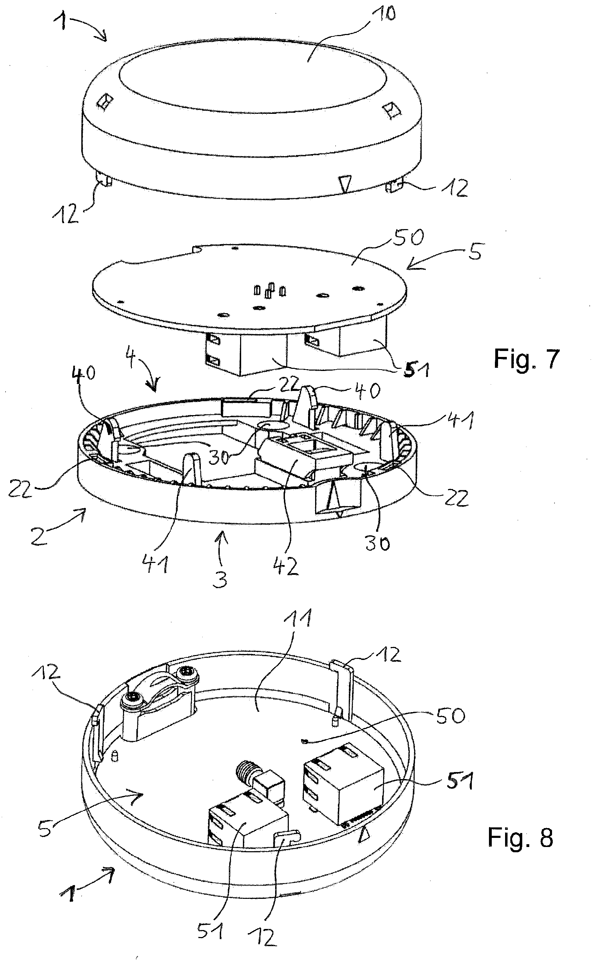

Die Figur 7 zeigt die Bauteile eines erfindungsgemäßen Gehäuses in der zweiten Ausführungsform, in diesem Fall zusammen mit einem elektrischen und/oder elektronischen Gerät 5, z.B. in Form einer mit elektrischen und/oder elektronischen Bauteilen 51 bestückten Platine 50. Dieses Gerät 5 soll im Gehäuseinneren 11 des aus dem Gehäuseoberteil 1 und dem Gehäuseunterteil 2 zusammengesetzten Gehäuses angeordnet werden. Die Figur 7 zeigt die Bauteile in einer Betrachtungsrichtung, in der der geschlossene Gehäusedeckel 10 des Gehäuseoberteils 1 erkennbar ist. Das Gehäuseunterteil 2 ist in seiner ersten Lage dargestellt, d.h. die zweite Gehäuseseite 4 weist zum Gehäuseoberteil 1 hin.

Das Gehäuseunterteil 2 weist wiederum erste Befestigungseinrichtungen 30 in Form von Befestigungslöchern auf sowie zweite Befestigungseinrichtungen 40, 41, 42 in Form einer Rasteinrichtung auf. Die Rasteinrichtung weist in ähnlicher Weise wie bei der ersten Ausführungsform wiederum Rasthaken 40, Justierfortsätze 41 sowie eine Rastfedereinrichtung 42 auf. Die Rastfedereinrichtung 42 ist in diesem Fall nicht als einfache Rastfeder ausgebildet, sondern in Form eines gefederten Schlittens, der in gleicher Weise ausgelenkt werden kann wie die Rastfeder 42 der ersten Ausführungsform.

Zur Befestigung des Gehäuseunterteils 2 am Gehäuseoberteil 1 weist das Gehäuseunterteil 2 mehrere in Form von nutartigen Aussparungen am Außenrand vorgesehene Befestigungsmittel 22 auf. Das Gehäuseoberteil 1 weist als korrespondierende Befestigungsmittel 12 an entsprechenden Positionen angeordnete, in Richtung zum Gehäuseunterteil 2 abragende Haken auf. Eine Verbindung zwischen dem Gehäuseoberteil 1 und dem Gehäuseunterteil 2 kann dann dadurch hergestellt werden, dass das Gehäuseoberteil 1 mit den Haken 12 in die Aussparungen 22 eingeführt wird und dann um einen bestimmten Drehwinkel gegenüber dem Gehäuseunterteil 2 gedreht wird, bis die Haken 12 eine Kante oder einen Vorsprung in den Aussparungen 22 hintergreifen.

Die Figur 8 zeigt das Gehäuseoberteil 1 in einer anderen Betrachtungsrichtung mit Blick in das Gehäuseinnere 11, in das bereits das Gerät 5 eingebaut ist.

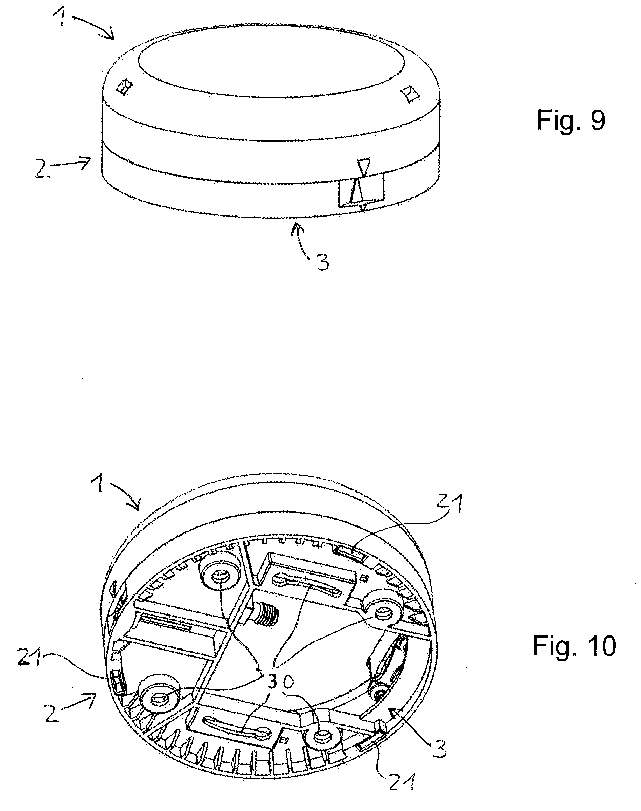

Die Figur 9 zeigt in einer vergleichbaren Betrachtungsrichtung wie die Figur 7 das aus dem mit dem Gehäuseunterteil 2 zusammengesetzten Gehäuseoberteil 1 gebildete Gehäuse.

Die Figur 10 zeigt die in Figur 9 dargestellte Einheit in einer Betrachtungsrichtung von unten, d.h. mit Blickrichtung auf die erste Gehäuseseite 3. Erkennbar sind insbesondere die Befestigungslöcher 30 sowie die die Befestigungsmittel 21 bildenden, randseitigen nutartigen Aussparungen.

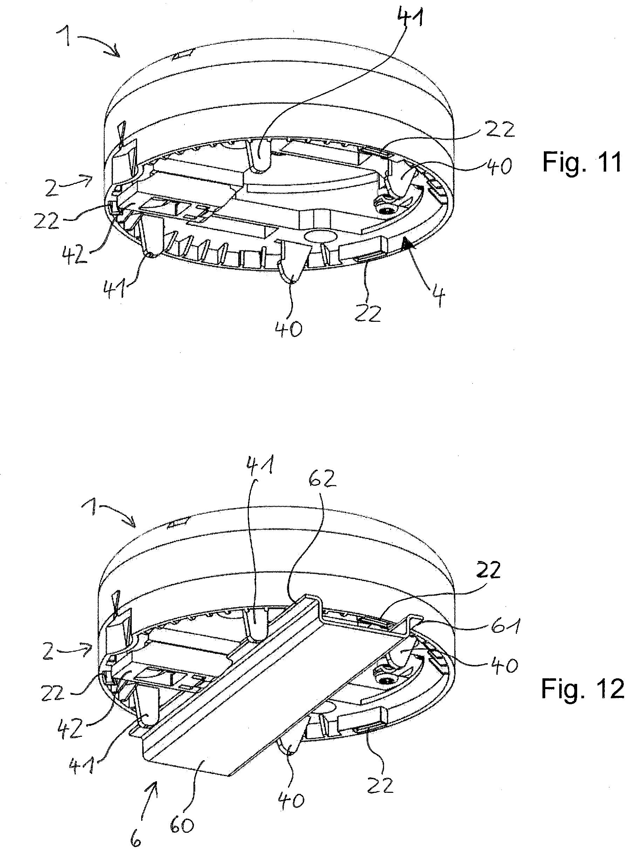

Die Figur 11 zeigt in einer ähnlichen Betrachtungsrichtung wie die Figur 10 das aus dem Gehäuseoberteil 1 und dem Gehäuseunterteil 2 gebildete Gehäuse, wobei das Gehäuseunterteil 2 sich nun in seiner zweiten Lage befindet, in der die zweiten Befestigungseinrichtungen 40, 41, 42 in Form der Rasteinrichtung wirksam sind. In diesem Zustand kann das Gehäuse mit dem Gehäuseunterteil 2 an einer Tragschiene 6 aufgerastet werden, wie die Figur 12 zeigt. Die Tragschiene 6 weist einen rückwärtigen Befestigungsbereich 60 auf, mit dem die Tragschiene 6 an einer Wand befestigt werden kann, z.B. an einer Rückwand eines Schaltschranks. Die Tragschiene 6 weist eine erste Rastkante 61 und davon abgewandt eine zweite Rastkante 62 auf. Die Befestigung des Gehäuseunterteils 2 an der Tragschiene 6 erfolgt derart, dass zunächst die Rasthaken 40 an der ersten Rastkante 61 eingehängt werden und dann mittels einer Verschwenkbewegung das Gehäuse mit dem Gehäuseunterteil 2 voran parallel zur Tragschiene 6 ausgerichtet wird, bis die Rastfedereinrichtung 42 hinter der zweiten Rastkante 62 einrastet.

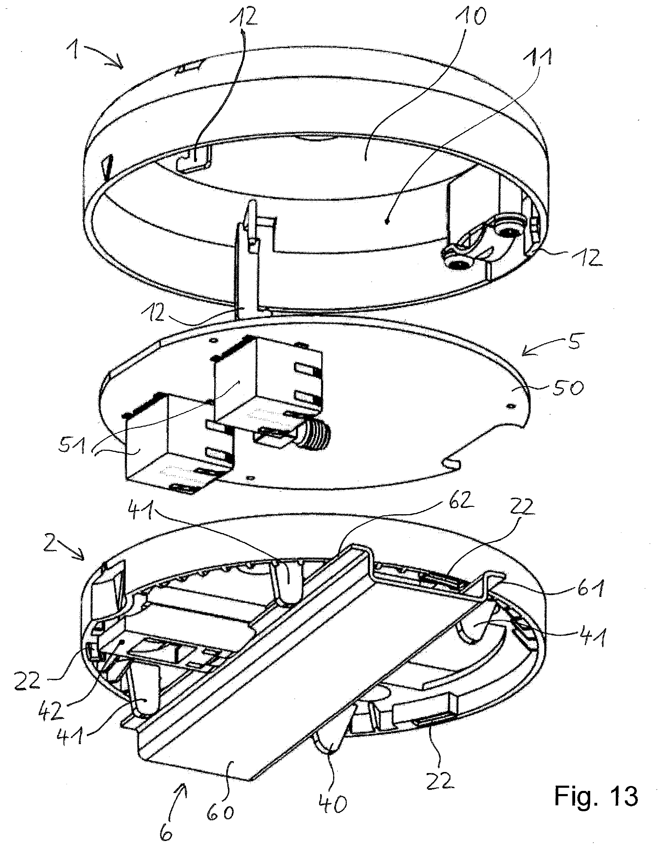

Die Figur 13 zeigt die Anordnung der Figur 12 in einer vergleichbaren Ansicht in Explosionsdarstellung, sodass die einzelnen Baueinheiten sichtbar sind.

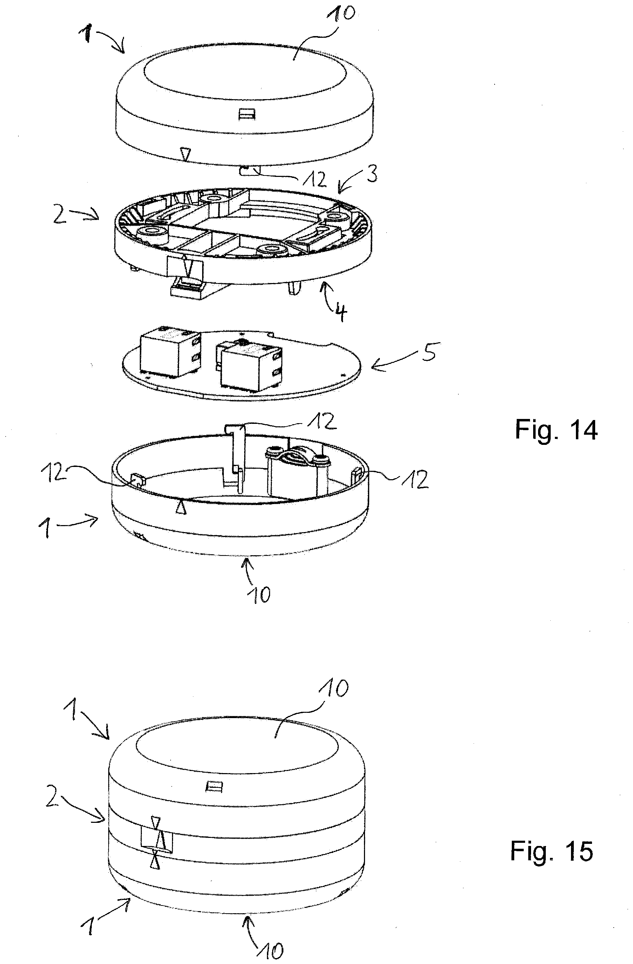

Wie die Figuren 14 und 15 zeigen, besteht eine weitere Anwendungsmöglichkeit der erfindungsgemäßen Gehäuseteile, d.h. des Gehäuseoberteils 1 und des Gehäuseunterteils 2, darin, dass ein Gehäuseunterteil 2 mit zwei Gehäuseoberteilen 1 zusammengesetzt wird. Insbesondere dann, wenn die Befestigungsmittel 21, 22 des Gehäuseunterteils 2 sowohl hinsichtlich der ersten Gehäuseseite 3 als auch hinsichtlich der zweiten Gehäuseseite 4 gleich ausgebildet sind, können zwei identisch ausgebildete Gehäuseoberteile 1 verwendet werden. Auf diese Weise kann ein Gehäuse mit größerem Bauraum zur Verfügung gestellt werden. Zudem ergeben sich erweiterte Befestigungsmöglichkeiten z.B. durch Ankleben des Gehäuses über einen Gehäusedeckel 10 an einer ebenen Fläche.

In dem Gehäuse kann wiederum das Gerät 5 angeordnet sein. Das in Figur 14 oben dargestellte Gehäuseoberteil 1 wird über seine korrespondierenden Befestigungsmittel 12 mit den auf der ersten Gehäuseseite 3 zugänglichen Befestigungsmitteln 21 des Gehäuseunterteils 2 verbunden. Das in Figur 14 unten dargestellte Gehäuseoberteil 1 wird mit seinen korrespondierenden Befestigungsmitteln 12 mit den von der zweiten Gehäuseseite 4 zugänglichen Befestigungsmitteln 22 zusammengefügt. Auf diese Weise kann das in Figur 15 im zusammengesetzten Zustand dargestellte Gehäuse gebildet werden.

## Patentansprüche

1. Gehäuse eines elektrischen und/oder elektronischen Gerätes (5), wobei das Gehäuse wenigstens ein Gehäuseoberteil (1) und ein mit dem Gehäuseoberteil (1) verbindbares Gehäuseunterteil (2) aufweist und das Gehäuse im zusammengebauten Zustand des Gehäuseoberteils (1) mit dem Gehäuseunterteil (2) einen Gehäuseinnenraum (11) umgibt, in dem elektrische und/oder elektronische Komponenten (50, 51) des Gerätes (5) angeordnet werden können, wobei das Gehäuseunterteil (2) Befestigungsmittel (21, 22) aufweist, die mit korrespondierenden Befestigungsmitteln (12) des Gehäuseoberteils (1) zur Verbindung des Gehäuseunterteils (2) mit dem Gehäuseoberteil (1) zusammenfügbar sind, wobei das Gehäuseunterteil (2) eine erste Gehäuseseite (3) und eine zweite Gehäuseseite (4) aufweist, die von der ersten Gehäuseseite (3) fort weist, **dadurch gekennzeichnet, dass** das Gehäuseunterteil (2) in wenigstens zwei unterschiedlichen Lagen mittels seiner Befestigungsmittel (21, 22) mit den korrespondierenden Befestigungsmitteln (12) des Gehäuseoberteils (1) zur Verbindung des Gehäuseunterteils (2) mit dem Gehäuseoberteil (1) zusammenfügbar ist, derart, dass in einer ersten Lage die zweite Gehäuseseite (4) des Gehäuseunterteils (2) zum Gehäuseoberteil (1) hin ausgerichtet ist und in einer zweiten Lage die erste Gehäuseseite (3) des Gehäuseunterteils (2) zum Gehäuseoberteil (1) hin ausgerichtet ist, wobei das Gehäuse zur Montage des Gehäuseunterteils (2) auf einem ersten Befestigungsuntergrund eingerichtet ist, wenn sich das Gehäuseunterteil (2) in seiner ersten Lage befindet, und das Gehäuse zur Montage des Gehäuseunterteils (2) auf einem zweiten Befestigungsuntergrund (6) eingerichtet ist, wenn sich das Gehäuseunterteil (2) in seiner zweiten Lage befindet, wobei der zweite Befestigungsuntergrund sich von dem ersten Befestigungsuntergrund unterscheidet.

2. Gehäuse nach dem vorhergehenden Anspruch, **dadurch gekennzeichnet, dass** das Gehäuseunterteil (2) erste Befestigungseinrichtungen (30), die in der ersten Lage wirksam sind und zur Montage des Gehäuseunterteils (2) auf dem ersten Befestigungsuntergrund eingerichtet sind, und zweite Befestigungseinrichtungen (40, 41, 42) aufweist, die in der zweiten Lage wirksam sind und zur Montage des Gehäuseunterteils (2) auf dem zweiten Befestigungsuntergrund eingerichtet sind.

3. Gehäuse nach dem vorhergehenden Anspruch, **dadurch gekennzeichnet, dass** die erste Befestigungseinrichtung (30) als eines oder mehrere Befestigungslöcher ausgebildet ist, durch die Schrauben oder ähnliches für eine Befestigung des Gehäuseunterteils (2) am ersten Befestigungsuntergrund geführt werden können.

4. Gehäuse nach einem der Ansprüche 2 bis 3, **dadurch gekennzeichnet, dass** die zweite Befestigungseinrichtung (40, 41, 42) als Rasteinrichtung zur rastenden Befestigung des Gehäuseunterteils an einer Tragschiene (6) der elektrischen Installationstechnik ausgebildet ist.

5. Gehäuse nach dem vorhergehenden Anspruch, **dadurch gekennzeichnet, dass** die Rasteinrichtung wenigstens einen von der zweiten Gehäuseseite (4) abragenden Rasthaken (40) aufweist, der zum Einrasten an einer ersten Rastkante (61) der Tragschiene (6) eingerichtet ist.

6. Gehäuse nach dem vorhergehenden Anspruch, **dadurch gekennzeichnet, dass** die Rasteinrichtung wenigstens eine von der zweiten Gehäuseseite (4) abragende Rastfedereinrichtung (42) aufweist, die zum federnden Einrasten auf einer zweiten Rastkante (62) der Tragschiene (6), die von der ersten Rastkante (61) abgewandt ist, eingerichtet ist.

7. Gehäuse nach einem der vorhergehenden Ansprüche, **dadurch gekennzeichnet, dass** das Gehäuseunterteil (2) auf der ersten Gehäuseseite (3) Befestigungsmittel (21) aufweist, die mit korrespondierenden Befestigungsmitteln (12) des Gehäuseoberteils (1) zur Verbindung des Gehäuseunterteils (2) mit dem Gehäuseoberteil (1) zusammenfügbar sind, wenn die erste Gehäuseseite (3) des Gehäuseunterteils (2) zum Gehäuseoberteil (1) ausgerichtet ist.

8. Gehäuse nach einem der vorhergehenden Ansprüche, **dadurch gekennzeichnet, dass** das Gehäuseunterteil (2) an der zweiten Gehäuseseite (4) Befestigungsmittel (22) aufweist, die mit den korrespondierenden Befestigungsmitteln (12) des Gehäuseoberteils (1) zur Verbindung des Gehäuseunterteils (2) mit dem Gehäuseoberteil (1) zusammenfügbar sind, wenn die zweite Gehäuseseite (4) des Gehäuseunterteils (2) zum Gehäuseoberteil (1) ausgerichtet ist.

9. Gehäuse nach einem der vorhergehenden Ansprüche, **dadurch gekennzeichnet, dass** das Gehäuseoberteil (1) einen Gehäusedeckel (10) aufweist, durch den das Gehäuse an der vom Gehäuseunterteil (2) fortweisenden Seite abgeschlossen ist.

10. Gehäuse nach einem der vorhergehenden Ansprüche, **dadurch gekennzeichnet, dass** das Gehäuse aus wenigstens den folgenden Teilen gebildet ist:
a) ein Gehäuseoberteil (1),
b) ein Gehäuseunterteil (2), das mit seinen Befestigungsmitteln (21, 22) an seiner ersten Gehäuseseite (3) mit den korrespondierenden Befestigungsmitteln (12) des Gehäuseoberteils (1) zusammengefügt ist und damit am Gehäuseoberteil (1) befestigt ist,
c) ein weiteres Gehäuseoberteil (1), das an zweiten Gehäuseseite (4) des Gehäuseunterteils (2) an diesem befestigt ist, indem die an der zweiten Gehäuseseite (4) wirksamen Befestigungsmittel (21, 22) des Gehäuseunterteils (2) mit den korrespondierenden Befestigungsmitteln (12) des weiteren Gehäuseoberteils (1) zusammengefügt sind.

11. Gehäuse nach einem der vorhergehenden Ansprüche, **dadurch gekennzeichnet, dass** das Gehäuseoberteil (1) zur Befestigung eines weiteren Gehäuseteils an der vom Gehäuseunterteil (2) fortweisenden Seite des Gehäuseoberteils (1) eingerichtet ist.

## Claims

1. Housing of an electrical and/or electronic device (5), wherein the housing has at least one housing upper part (1) and one housing lower part (2) which can be connected to the housing upper part (1) and the housing, in the assembled state of the housing upper part (1) with the housing lower part (2), surrounds a housing interior (11) in which electrical and/or electronic components (50, 51) of the device (5) can be arranged, wherein the housing lower part (2) has fastening means (21, 22) which can be joined to corresponding fastening means (12) of the housing upper part (1) for connecting the housing lower part (2) to the housing upper part (1), wherein the housing lower part (2) has a first housing side (3) and a second housing side (4) which faces away from the first housing side (3), **characterized in that** the housing lower part (2) can be joined by means of its fastening means (21, 22) to the corresponding fastening means (12) of the housing upper part (1) for connecting the housing lower part (2) to the housing upper part (1) in at least two different positions in such a way that, in a first position, the second housing side (4) of the housing lower part (2) is oriented towards the housing upper part (1) and, in a second position, the first housing side (3) of the housing lower part (2) is oriented towards the housing upper part (1), wherein the housing is designed for mounting the housing lower part (2) on a first fastening substrate when the housing lower part (2) is in its first position, and the housing is designed for mounting the housing lower part (2) on a second fastening substrate (6) when the housing lower part (2) is in its second position, wherein the second fastening substrate differs from the first fastening substrate.

2. Housing according to the preceding claim, **characterized in that** the housing lower part (2) has first fastening devices (30) which are active in the first position and are designed for mounting the housing lower part (2) on the first fastening substrate, and second fastening devices (40, 41, 42) which are active in the second position and are designed for mounting the housing lower part (2) on the second fastening substrate.

3. Housing according to the preceding claim, **characterized in that** the first fastening device (30) is designed as one or more fastening holes through which screws or the like can be guided for fastening the housing lower part (2) to the first fastening substrate.

4. Housing according to either of Claims 2 and 3, **characterized in that** the second fastening device (40, 41, 42) is designed as a latching device for fastening the housing lower part in a latching manner to a mounting rail (6) used in the field of electrical installation technology.

5. Housing according to the preceding claim, **characterized in that** the latching device has at least one latching hook (40) which protrudes from the second housing side (4) and is designed to lock onto a first latching edge (61) of the mounting rail (6).

6. Housing according to the preceding claim, **characterized in that** the latching device has at least one latching spring device (42) which protrudes from the second housing side (4) and is designed for locking onto a second latching edge (62) of the mounting rail (6), which second latching edge is averted from the first latching edge (61), with a spring action.

7. Housing according to one of the preceding claims, **characterized in that** the housing lower part (2) has, on the first housing side (3), fastening means (21) which can be joined to corresponding fastening means (12) of the housing upper part (1) for connecting the housing lower part (2) to the housing upper part (1) when the first housing side (3) of the housing lower part (2) is oriented towards the housing upper part (1).

8. Housing according to one of the preceding claims, **characterized in that** the housing lower part (2) has, on the second housing side (4), fastening means (22) which can be joined to the corresponding fastening means (12) of the housing upper part (1) for connecting the housing lower part (2) to the housing upper part (1) when the second housing side (4) of the housing lower part (2) is oriented towards the housing upper part (1).

9. Housing according to one of the preceding claims, **characterized in that** the housing upper part (1) has a housing cover (10) by way of which the housing is closed off on that side which faces away from the housing lower part (2).

10. Housing according to one of the preceding claims, **characterized in that** the housing is formed from at least the following parts:
a) a housing upper part (1),
b) a housing lower part (2) which, by way of its fastening means (21, 22), is joined on its first housing side (3) to the corresponding fastening means (12) of the housing upper part (1) and thereby is fastened to the housing upper part (1),
c) a further housing upper part (1) which, on the second housing side (4) of the housing lower part (2), is fastened to the said housing lower part by way of the fastening means (21, 22) of the housing lower part (2), which fastening means act on the second housing side (4), being joined to the corresponding fastening means (12) of the further housing upper part (1).

11. Housing according to one of the preceding claims, **characterized in that** the housing upper part (1) is designed for fastening a further housing part to that side of the housing upper part (1) which faces away from the housing lower part (2).

## Revendications

1. Boîtier d'un appareil (5) électrique et/ou électronique, le boîtier possédant au moins une partie supérieure de boîtier (1) et une partie inférieure de boîtier (2) qui peut être reliée à la partie supérieure de boîtier (1) et le boîtier, dans l'état assemblé de la partie supérieure de boîtier (1) avec la partie inférieure de boîtier (2), entourant un espace intérieur de boîtier (11) dans lequel peuvent être disposés des composants électriques et/ou électroniques (50, 51) de l'appareil (5), la partie inférieure de boîtier (2) possédant des moyens de fixation (21, 22) qui peuvent être assemblés avec des moyens de fixation (12) correspondants de la partie supérieure de boîtier (1) en vue de relier la partie inférieure de boîtier (2) à la partie supérieure de boîtier (1), la partie inférieure de boîtier (2) possédant un premier côté de boîtier (3) et un deuxième côté de boîtier (4), lequel est tourné à l'écart du premier côté de boîtier (3), **caractérisé en ce que** la partie inférieure de boîtier (2) peut être assemblée dans au moins deux positions différentes au moyen de ses moyens de fixation (21, 22) avec les moyens de fixation (12) correspondants de la partie supérieure de boîtier (1) en vue de relier la partie inférieure de boîtier (2) à la partie supérieure de boîtier (1), de telle sorte que dans une première position, le deuxième côté de boîtier (4) de la partie inférieure de boîtier (2) est orienté en direction de la partie supérieure de boîtier (1) et, dans une deuxième position, le premier côté de boîtier (3) de la partie inférieure de boîtier (2) est orienté en direction de la partie supérieure de boîtier (1), le boîtier étant conçu pour le montage de la partie inférieure de boîtier (2) sur un premier support de fixation lorsque la partie inférieure de boîtier (2) se trouve dans sa première position, et le boîtier étant conçu pour le montage de la partie inférieure de boîtier (2) sur un deuxième support de fixation (6) lorsque la partie inférieure de boîtier (2) se trouve dans sa deuxième position, le deuxième support de fixation étant différent du premier support de fixation.

2. Boîtier selon la revendication précédente, **caractérisé en ce que** la partie inférieure de boîtier (2) possède des premiers dispositifs de fixation (30) qui sont opérationnels dans la première position et qui sont conçus pour le montage de la partie inférieure de boîtier (2) sur le premier support de fixation, et des deuxièmes dispositifs de fixation (40, 41, 42) qui sont opérationnels dans la deuxième position et qui sont conçus pour le montage de la partie inférieure de boîtier (2) sur le deuxième support de fixation.

3. Boîtier selon la revendication précédente, **caractérisé en ce que** le premier dispositif de fixation (30) est réalisé sous la forme d'un ou plusieurs trous de fixation à travers lesquels peuvent être passées les vis ou similaire pour une fixation de la partie inférieure de boîtier (2) au premier support de fixation.

4. Boîtier selon l'une des revendications 2 à 3, **caractérisé en ce que** le deuxième dispositif de fixation (40, 41, 42) est réalisé sous la forme d'un dispositif d'enclipsage destiné à la fixation par enclipsage de la partie inférieure de boîtier à un rail porteur (6) de la technologie d'installation électrique.

5. Boîtier selon la revendication précédente, **caractérisé en ce que** le dispositif d'enclipsage possède au moins un crochet d'enclipsage (40) qui fait saillie depuis le deuxième côté de boîtier (4), lequel est conçu pour s'enclipser au niveau d'un premier bord d'enclipsage (61) du rail porteur (6).

6. Boîtier selon l'une des revendications précédentes, **caractérisé en ce que** le dispositif d'enclipsage possède au moins un dispositif à ressort d'enclipsage (42) qui fait saillie depuis le deuxième côté de boîtier (4), lequel est conçu pour l'enclipsage avec effet de ressort sur un deuxième bord d'enclipsage (62) du rail porteur (6), lequel est à l'opposé du premier bord d'enclipsage (61) .

7. Boîtier selon l'une des revendications précédentes, **caractérisé en ce que** la partie inférieure de boîtier (2) possède des moyens de fixation (21) sur le premier côté de boîtier (3), lesquels peuvent être assemblés avec des moyens de fixation (12) correspondants de la partie supérieure de boîtier (1) en vue de relier la partie inférieure de boîtier (2) à la partie supérieure de boîtier (1) lorsque le premier côté de boîtier (3) de la partie inférieure de boîtier (2) est orienté vers la partie supérieure de boîtier (1).

8. Boîtier selon la revendication précédente, **caractérisé en ce que** la partie inférieure de boîtier (2) possède des moyens de fixation (22) sur le deuxième côté de boîtier (4), lesquels peuvent être assemblés avec les moyens de fixation (12) correspondants de la partie supérieure de boîtier (1) en vue de relier la partie inférieure de boîtier (2) à la partie supérieure de boîtier (1) lorsque le deuxième côté de boîtier (4) de la partie inférieure de boîtier (2) est orienté vers la partie supérieure de boîtier (1).

9. Boîtier selon l'une des revendications précédentes, **caractérisé en ce que** la partie supérieure de boîtier (1) possède un couvercle de boîtier (10) par lequel le boîtier est fermé au niveau du côté à l'opposé de la partie inférieure de boîtier (2).

10. Boîtier selon l'une des revendications précédentes, **caractérisé en ce que** le boîtier est constitué au moins des parties suivantes :
a) une partie supérieure de boîtier (1),
b) une partie inférieure de boîtier (2) qui, avec ses moyens de fixation (21, 22) sur son premier côté de boîtier (3), est assemblée avec les moyens de fixation (12) correspondants de la partie supérieure de boîtier (1) et est ainsi fixée à la partie supérieure de boîtier (1),
c) une partie supérieure de boîtier (1) supplémentaire, qui est fixée au deuxième côté de boîtier (4) de la partie inférieure de boîtier (2) en assemblant les moyens de fixation (21, 22) de la partie inférieure de boîtier (2) opérationnels au niveau du deuxième côté de boîtier (4) avec les moyens de fixation (12) correspondants de la partie supérieure de boîtier (1) supplémentaire.

11. Boîtier selon l'une des revendications précédentes, **caractérisé en ce que** la partie supérieure de boîtier (1) est conçue pour la fixation d'une partie de boîtier supplémentaire au côté de la partie supérieure de boîtier (1) à l'opposé de la partie inférieure de boîtier (2).
